## Europäisches Patentamt
## European Patent Office
## Office européen des brevets

(19)

(11) Veröffentlichungsnummer: **0 274 347**
**A1**

(12) # EUROPÄISCHE PATENTANMELDUNG

(21) Anmeldenummer: **87810669.9**

(22) Anmeldetag: **16.11.87**

(51) Int. Cl.⁴: **H 03 H 1/00**

(30) Priorität: **24.11.86 CH 4697/86**

(43) Veröffentlichungstag der Anmeldung:
**13.07.88 Patentblatt 88/28**

(84) Benannte Vertragsstaaten:
**BE CH DE FR LI NL**

(71) Anmelder: **FELLER AG.**
**Bergstrasse**
**CH-8810 Horgen (CH)**

(72) Erfinder: **Witzig, Martin A.**
**Einsiedlerstrasse 11**
**CH-8810 Horgen (CH)**

(74) Vertreter: **White, William et al**
**Isler AG Patentanwalts-Bureau Walchestrasse 23**
**CH-8006 Zürich (CH)**

(54) **Störschutzfilter für eine Wechselstrom-Netzleitung.**

(57) Zur Verringerung von hochfrequenten Störungen weist das Störschutzfilter (1) Reihenschaltungen (2,3,4) eines Widerstandes (5,6,7) und eines Kondensators (8,9,10) auf. Diese Reihenschaltungen (2,3,4) liegen zwischen dem Phasenleiter (L.L') und dem Nulleiter (N,N') der Netzleitung sowie zwischen dem Phasenleiter (L,L') bzw. dem Nulleiter (N,N') und dem Erdleiter (E,E') der Netzleitung. Die Widerstände (5,6,7) absorbieren die hochfrequente Störenergie. Ihr Widerstandswert ist vorzugsweise der Wellenimpedanz der Netzleitung angepasst. Die Kondensatoren (8,9,10) wirken als einstufige Hochpassfilter, um eine durch die Widerstände (5,6,7) verursachte hohe Verlustleistung bei der niedrigen Netzfrequenz zu vermeiden. Dieses Störschutzfilter (1) ist reflexionsfrei und verringert zudem in Netzleitungssystemen mit mehreren Stichleitungen den Störsignalpegel fortlaufend, wenn in jede Stichleitung ein solches Störschutzfilter geschaltet ist.

FIG. 1

EP 0 274 347 A1

**Beschreibung**

Störschutzfilter für eine Wechselstrom-Netzleitung

Die vorliegende Erfindung bezieht sich auf ein Störschutzfilter gemäss dem Oberbegriff des Patentanspruchs 1.

Elektrische und insbesondere elektronische Geräte sind derzeit üblicherweise mit Störschutzfiltern ausgerüstet, welche dafür sorgen, dass elektrische Störsignale höherer Frequenzen als die Netzfrequenz von der Netzleitung nicht in das Gerät oder/und vom Gerät in das Netz geführt werden. Meistens werden solche Störschutzfilter am Geräteeingang eingebaut. Es ist aber auch bekannt, Störschutzfilter in eine Netzsteckdose einzubauen oder als in eine Netzsteckdose einsteckbares Vorsatzfilter auszubilden, in welches die Netzleitung des Verbrauchergeräts ihrerseits einsteckbar ist.

Typisch für die bekannten Störschutzfilter ist der Umstand, dass sie ausschliesslich als Tiefpassfilter unter Benutzung der reaktiven Bauteile Kondensator und Spule ausgebildet sind. Nachteilig bei dieser Anordnung der reaktiven Bauteile ist deren Impedanz bei hohen Frequenzen. Einerseits wirken die zur Netzleitung parallel geschalteten Kondensatoren als Leitungskurzschluss und andererseits täuschen die in Reihe der Netzleitung geschalteten Spulen ein offenes Leitungsende vor. Diese beiden Impedanzzustände, Leitung mit Kurzschluss oder offenem Ende, verursachen eine Totalreflexion der einfallenden Störsignale, indem beispielsweise die Störsignale von dem an die Netzleitung angeschlossenen Gerät ferngehalten, jedoch zurück ins Netz reflektiert werden. Dadurch wird ein Verschleppen der Störsignale in andere, an das Netz angeschlossene Geräte möglich.

Aufgabe der Erfindung ist, ein Störschutzfilter der eingangs genannten Art zu schaffen, welches Reflexionen von Störsignalen verhindert oder zumindest erheblich herabsetzt.

Erfindungsgemäss weist das Störschutzfilter die im kennzeichnenden Teil des Patentanspruchs 1 angeführten Merkmale auf.

Die Anordnung mindestens eines resistiven Schaltungselements parallel zur Netzleitung bewirkt, dass die Eingangsimpedanz des Störschutzfilters wesentlich herabgesetzt ist. Insbesondere dann, wenn durch entsprechende Wahl des oder der Widerstandswerte die Eingangsimpedanz des Störschutzfilters in vorteilhafter Weise der Wellenimpedanz der die Störsignale zuführenden Netzleitung mindestens angenähert angepasst ist, wird der einfallenden Welle des Störsignals ein unendlich langes Leitungsstück vorgetäuscht. Die einfallende Störwelle wird deshalb nicht in die Netzleitung reflektiert, wie dies bei reaktiven Störschutzfiltern zufolge des vorhandenen Impedanzsprungs unvermeidbar der Fall ist. Demnach wird die Energie der Störwelle beim erfindungsgemässen Störschutzfilter nahezu vollständig absorbiert, d.h. in Wärme umgewandelt. Liegt ein Netzleitungssystem mit mehreren Stichleitungen mit angeschlossenen Verbrauchergeräten vor, wie dies üblicherweise der Fall ist, so wird dann, wenn in jede Stichleitung ein Störschutzfilter nach der Erfindung geschaltet ist, durch jede Stichleitung die Störenergie jeweils angenähert um die Hälfte herabgesetzt, d.h. nur die Hälfte der vor der Stichleitung vorhandenen Störenergie pflanzt sich auf dem Leitungsabschnitt nach der Stichleitung weiter fort. Somit lassen sich nicht nur die einzelnen angeschlossenen Geräte gegen das Eindringen von Störsignalen schützen, sondern es kann auch im ganzen Netzleitungssystem die Störenergie erheblich herabgesetzt werden.

Um eine mindestens angenäherte Anpassung des vorliegenden Störschutzfilters an die Wellenimpedanz der Netzleitung zu erzielen, muss das resistive Schaltungselement bzw. eine Kombination mehrerer resistiver Schaltungselemente einen der Wellenimpedanz der Netzleitung entsprechenden Widerstandswert aufweisen. Da jedoch die Impedanz der Netzleitung tiefe Werte von unterhalb 300 Ohm annimmt, würden die parallel zur Netzleitung geschalteten resistiven Schaltungselemente bei der niedrigen Netzfrequenz eine unannehmbar hohe Verlust leistung entstehen lassen. Erfindungsgemäss ist jedes resistive Schaltungselement deshalb mit einem Hochpassfilter versehen, um eine Anpassung der Eingangsimpedanz des Störschutzfilters auf einen Frequenzbereich zu beschränken, der oberhalb der Netzfrequenz liegt, beispielsweise auf einem Frequenzbereich ab etwa 10 kHz.

Besonders vorteilhaft ist es, ein erfindungsgemässes Störschutzfilter einem reaktiven Störschutz-Tiefpassfilter bekannter Art für das Gerät bzw. jedes Gerät vorzuschalten.

Ausführungsbeispiele des Erfindungsgegenstandes werden nachstehend anhand von Zeichnungen erläutert. Es zeigen:

Fig. 1 ein Schaltschema eines Störschutzfilters nach der Erfindung mit Kondensatoren als einstufige Hochpassfilter;

Fig. 2 ein Schaltschema eines Störschutzfilters gemäss Fig. 1 zusammen mit einem bekannten reaktiven Tiefpassfilter für ein Gerät;

Fig. 3 ein Schaltschema eines Störschutzfilters nach der Erfindung mit Spulen und Kondensatoren als Hochpassfilter;

Fig. 4 ein Schema eines Netzleitungssystems mit mehreren Störschutzfiltern nach der Erfindung; und

Fig. 5 eine Seitenansicht, teilweise im Schnitt, einer Einbau-Netzsteckdose mit einem Störschutzfilter nach der Erfindung.

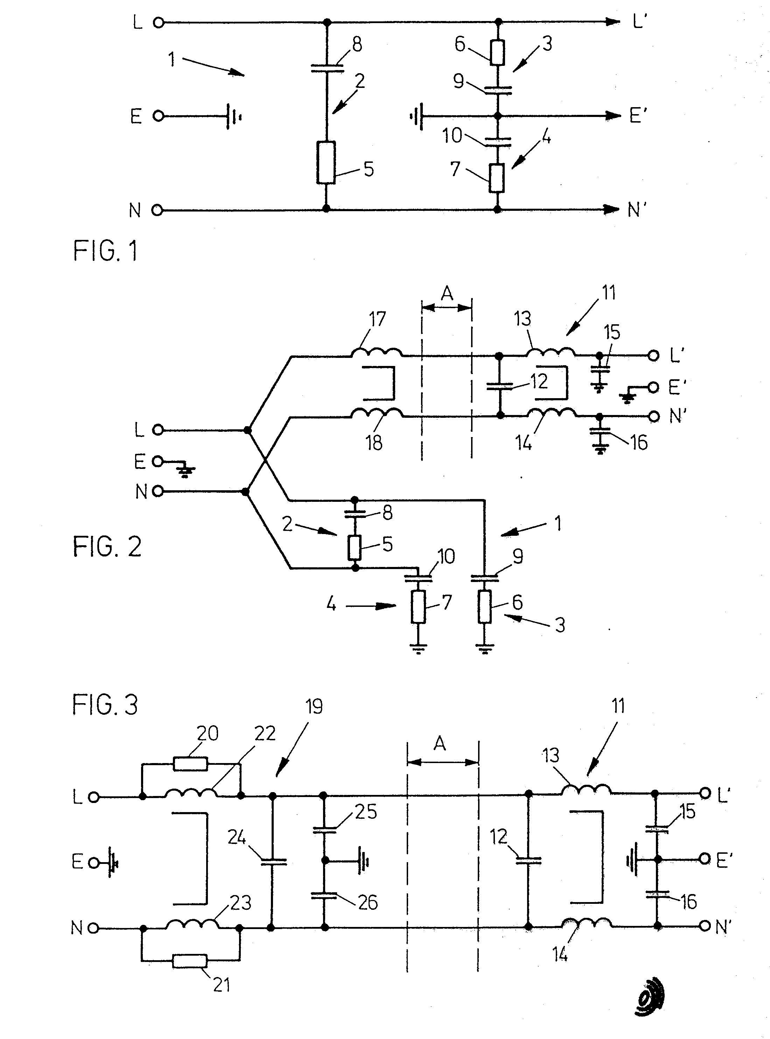

Das in Fig. 1 dargestellte Störschutzfilter 1 für eine Wechselstrom-Netzleitung und für ein mit dieser verbundenes Gerät weist Anschlussklemmen L, N und E für die Netzleitung und entsprechende Anschlussleiter L', N' und E' für das nicht dargestellte Gerät auf. Mit L bzw. L' ist hierbei ein Phasenleiter der Netzleitung bezeichnet, mit N bzw. N' ein Nulleiter der Netzleitung und mit E bzw. E' ein Erdleiter der Netzleitung, der in bekannter Weise als Schutzleiter vorgesehen ist und deshalb, wie angedeutet, mit metallischen Teilen des Störschutzfilters, beispielsweise einem nicht dargestellten metallischen Schutzgehäuse, in elektrischer Verbindung steht.

Gemäss an sich bekannter Filtertechnik weist das dargestellte Störschutzfilter 1 drei Schaltungsanordnungen 2, 3 und 4 auf, von welchen die Schaltungsanordnung 2 zwischen Phasenleiter L bzw. L' und den Nulleiter N bzw. N' geschaltet ist und dazu vorgesehen ist, symmetrische Störsignale zu absorbieren. Zur Absorption asymmetrischer Störsignale sind die Schaltungsanordnungen 3 und 4 einerseits zwischen den Phasenleiter L bzw. L' und den Erdleiter E bzw. E' geschaltet, und andererseits zwischen den Nulleiter N bzw. N' und den Erdleiter E bzw. E' geschaltet.

Jede Schaltungsanordnung 2, 3, 4 enthält die Reihenschaltung eines resistiven Schaltungselements oder Widerstands 5, 6, 7 und eines kapazitiven Elements oder Kondensators 8, 9, 10. Die resistiven Elemente oder Widerstände 5, 6, 7 sind von entscheidender Bedeutung, weil sie zufolge ihrer parallelen Schaltung bei entsprechender Dimensionierung ihrer Widerstandswerte eine die symmetrisch oder asymmetrisch auf den Leitungen L und N bzw. L' und N' erscheinenden Störsignale absorbierende Wirkung haben, d.h. die elektrische oder elektromagnetische Störenergie in Wärme umwandeln, ohne einen nennenswerten Teil der Störenergie oder überhaupt jegliche Störenergie, die über die Netzleitung oder vom angeschlossenen Gerät auf die Störschutzfilter gelangt, auf die Netzleitung oder in das Gerät zu reflektieren.

Besonders vorteilhaft ist es, die Widerstandswerte der resistiven Elemente 5, 6 und 7 so zu bestimmen, dass durch den ohmschen Anteil der Impedanz des Störschutzfilters 1 eine mindestens angenäherte Anpassung der Eingangsimpedanz des Störschutzfilters 1 an die Wellenimpedanz der Netzleitung erfolgt. Wenn die Netzleitung mit einem Widerstand entsprechend der charakteristischen Wellenimpedanz der Netzleitung abgeschlossen ist, werden einfallende Störsignale nicht zurück auf die Netzleitung reflektiert. In einem typischen Fall betragen die symmetrische Wellenimpedanz der Netzleitung etwa 100 Ohm und die asymmetrische Wellenimpedanz etwa 70 Ohm. Daraus ergibt sich, dass das resistive Element 5 einen Wider standswert von etwa 155 Ohm und die resistiven Elemente 6 und 7 einen solchen von je etwa 140 Ohm haben sollen.

Derart niedrige Widerstandswerte der parallel zur Netzleitung geschalteten Abschlusswiderstände würden sich jedoch verbieten, da jeder Widerstand bei der Netzfrequenz von 50 Hz oder 60 Hz und einer Netzspannung von 220 V bzw. 110 V eine Verlustleistung von mehreren hundert Watt vernichten müsste. Erfindungsgemäss ist demnach jedem resistiven Element 5, 6, 7 ein Hochpassfilter zugeordnet, um die niederfrequenten Signale von den resistiven Elementen fernzuhalten. Bei dem in Fig. 1 dargestellten Ausführungsbeispiel des erfindungsgemässen Störschutzfilters sind einstufige Hochpassfilter vorgesehen, die je einen in Reihe mit dem resistiven Element 5, 6, 7 geschalteten Kondensator 8, 9, 10 enthalten. Vorzugsweise ist die Kapazität jedes Kondensators 8, 9, 10 derart bestimmt, dass die Grenzfrequenz dieses Hochpassfilters bei etwa 10 kHz liegt. Dadurch wird bewirkt, dass die niederfrequenten Signale, insbesondere die Netzfrequenzströme, nicht in die absorbierenden resistiven Elemente 5, 6 und 7 gelangen können, während alle höherfrequenten Signale, insbesondere also die meist impulsförmigen Störsignale, in den resistiven Elementen 5, 6 und 7 reflexionsfrei absorbiert werden. Für den vorgängig angeführten typischen Fall von Wellenimpedanzen der Netzleitung beträgt dann der Kapazitätswert des Kondensators 8 um 0,05 Mikrofarad, während für die Kondensa toren 9 und 10 aus Sicherheitsgründen ein wesentlich kleinerer Wert von höchstens 5 Nanofarad gewählt wird.

Das in Fig. 1 schematisch dargestellte Störschutzfilter 1 kann als einzelnes Bauteil zwischen der Netzleitung und dem Netzeingang eines Geräts angeordnet sein. Es ist jedoch besonders vorteilhaft, das beschriebene Störschutzfilter 1 mit einem bekannten, üblichen Tiefpassfilter zu kombinieren, das, wie bereits erwähnt, meistens am Geräteeingang eingebaut und eine Schaltung reaktiver Bauteile, nämlich Spulen und Kondensatoren, enthält. In Fig. 2 ist eine solche Kombination des erfindungsgemässen Störschutzfilters 1 mit einem bekannten Tiefpassfilter 11 schematisch dargestellt.

Gemäss Fig. 2 ist an Klemmen L, N und E für den Phasenteiler, den Nulleiter und den Erdleiter der Netzleitung wiederum das Störschutzfilter 1 der Fig. 1 angeschlossen. Das Störschutzfilter 1 entspricht denjenigen der Fig. 1 und braucht deshalb nicht nochmals erläutert zu werden. Ferner steht mit den Klemmen L, N und E das Tiefpassfilter 11 in Verbindung, das in bekannter Weise einen eingangsseitigen Parallelkondensator 12 und je eine Spule 13 und 14 für den Phasenleiter L und den Nulleiter N enthält, wobei die beiden Spulen 13, 14 miteinander induktiv gekoppelt sind. Ausgangsseitig weist das Tiefpassfilter 11 zwei weitere Kondensatoren 15 und 16 auf, welche den ausgangsseitigen Phasenleiter L' und den Nulleiter N' mit dem Erdleiter E bzw. E' verbinden. Die aus gangsseitigen Leiter der Netzleitung sind als Klemmen L', N' und E' dargestellt, an welche das zu entstörende, vom Netz gelieferte Wechselstromenergie verbrauchende Gerät anzuschliessen ist.

An sich wirkt die in Fig. 2 dargestellte Schaltungsanordnung in der Weise, dass von den Netzanschlussklemmen L, N, E eintreffende, höherfrequente Störsignale durch das Tiefpassfilter 11 in bekannter Weise abgeblockt und am Eindringen in das Gerät über die Klemmen L', N', E' weitgehend gehindert werden, wobei für den Nutzwechselstrom mit der Netzfrequenz an den Spulen 13, 14 des Tiefpassfilters 11 praktisch kein Spannungsabfall auftritt. Solche Störsignale werden wegen der reaktiven Charakteristik des Tiefpassfilters 11 jedoch grundsätzlich zu den Netzanschlussklemmen L, N, E reflektiert. Da jedoch den Netzanschlussklemmen L, N, E das erfindungsgemässe Störschutzfilter 1 parallelgeschaltet ist, werden durch dieses nicht nur die von den Netzanschlussklemmen L, N, E einlaufenden Störsignale höherer Frequenz, sondern auch die vom Tiefpassfilter 11 reflektierten Störsignale höherer Frequenz wirkungsvoll absorbiert.

Anhand der Fig. 1 ist bereits erläutert worden, dass die grösste Absorption von Störsignalen durch das Störschutzfilter 1 dann erzielt wird, wenn dessen Impedanz in seinem wirksamen Frequenzbereich der Wellenimpedanz der Netzleitung angepasst ist. Da sowohl das Störschutzfilter 1 als auch das Tiefpassfilter 11 längs der Netzleitung zwischen den Netzanschlussklemmen L, N, E und den für den Anschluss des Geräts vorgesehenen Klemmen L', N', E' an verschiedenen Stellen angeordnet werden können, sind je nach Anordnung besondere Massnahmen vorteilhaft oder erforderlich.

In Fig. 2 ist angedeutet, dass sich zwischen der Anschlussstelle des Störschutzfilters 1 an die Netzleitung und der Anschlussstelle des Tiefpassfilters 11 an diese Netzleitung ein Abschnitt der Netzleitung mit Phasenleiter L und Nulleiter N befindet, der eine bestimmte Länge A hat. Die Länge A der Netzleitung ist offensichtlich von Einfluss auf die sich am Eingang des Störschutzfilters 1 bzw. an den Netzanschlussklemmen L, N zeigende Impedanz.

In einem ersten Fall ist die Länge A der Netzleitung verhältnismässig kurz, insbesondere wenn das Störschutzfilter 1 und das Tiefpassfilter 1 zu einer Baueinheit zusammengebaut sind. Es ist ersichtlich, dass in diesem Fall der eingangsseitige Parallelkondensator 12 des Tiefpassfilters 11 direkt an den Eingang des Störschutzfilters 1 zu liegen käme und dadurch die resistiven Elemente 5, 6 und 7 wechselstrommässig bzw. hochfrequenzmässig kurzschliessen würde. Damit wäre aber jede beabsichtigte Wirkung des Störschutzfilters 1 aufgehoben. Um dies zu vermeiden, sind in der zum Tiefpassfilter 11 führenden Netzleitung im Phasenleiter L und im Nulleiter N je eine Spule 17 bzw. 18 in Reihe angeordnet, wodurch das Störschutzfilter 1 hochfrequenzmässig vom Kondensator 12 des Tiefpassfilters 11 isoliert wird. Die Induktivitäten der Spulen 17 und 18 können und müssen wegen des erforderlichen verlustlosen Durchlasses des Netzstroms verhältnismässig klein sein und sind so zu wählen, dass die Spulen 17, 18 im Durchlassbereich des Störschutzfilters 1, also ab einer Frequenz von beispielsweise 10 kHz, eine im Vergleich zur Wellenimpedanz der Netzleitung hohe Impedanz aufweisen.

Wenn jedoch in einem zweiten Fall die Länge A der Netzleitung verhältnismässig gross ist, wobei eine Länge ab zwei Metern eines Netzkabels bereits ausreichend ist, so können die Spulen 17, 18 entfallen. Die Induktivität eines solchen Leiterabschnitts genügt dann, um den kurzschliessenden Einfluss des Kondensators 12 des Tiefpassfilters 11 auf den Eingang des Störschutzfilters zu eliminieren.

Ein dritter Fall liegt dann vor, wenn das Tiefpassfilter 11 eingangsseitig keinen Parallelkondensator 12 enthält. Dann isolieren die Reihenspulen 13 und 14 des Tiefpassfilters 11 den Eingang des Störschutzfilters 1 von den weiteren Kondensatoren 15, 16 des Tiefpassfilters 11, so dass die zusätzlichen Spulen 17 und 18 ebenfalls entfallen können.

In Fig. 3 ist eine Ausführungsform des erfindungsgemässen Störschutzfilters dargestellt, die zur Ausführungsform der Fig. 1 und 2 dual ist bezüglich der verwendeten reaktiven Schaltungselemente. Entsprechend Fig. 2 ist dieses duale Störschutzfilter 19 ebenfalls in Kombination mit dem Tiefpassfilter 11 angeordnet. Dementsprechend weist das Störschutzfilter 19 im Phasenleiter L und im Nulleiter N je einen Reihenwiderstand 20 bzw. 21 auf, wobei parallel zu jedem Widerstand 20, 21 eine Spule 22 bzw. 23 geschaltet ist. Die beiden Widerstände 20, 21 sind hochfrequenzmässig über einen Kondensator 24 zu einer Reihenschaltung geschaltet, welche mit den Parallelspulen 22, 23 eine mit den Netzanschlussklemmen L und N verbundene Parallelschaltung bildet.

Die Wirkung des Störschutzfilters 19 ist analog derjenigen des Störschutzfilters 1. In einem höherfrequenten Bereich weisen die Spulen 22, 23 und der Kondensator 24 Impedanzen auf, die im Vergleich zu den Widerstandswerten der Widerstände 20, 21 gross bzw. klein sind. Somit liegt in diesem höheren Frequenzbereich an den Netzanschlussklemmen L und N, das heisst zwischen dem Phasenleiter und dem Nulleiter der Netzleitung, effektiv die Reihenschaltung der beiden Widerstände 20 und 21. Diese resistive Reihenschaltung absorbiert deshalb alle einfallenden Störsignale höherer Frequenz. Eine Reflexion der einfallenden Störsignale in das Netz ist hierbei praktisch vollständig unterdrückt, wenn der Widerstandswert der Reihenschaltung der Widerstände 20, 21 an die Wellenimpedanz des Netzes angepasst ist, um einen angepassten resistiven Abschluss des Netzes zu bilden. Mit andern Worten ist es vorteilhaft, wenn jeder Widerstand 20, 21 einen Wert hat, der angenähert halb so gross wie die Wellenimpedanz des Netzes ist.

Die Spulen 22, 23 wirken zusammen mit den Kondensatoren 24 wiederum als Hochpassfilter für die durch die Widerstände 20, 21 fliessenden Störströme, wobei die Grenzfrequenz dieses Hochpassfilters bei etwa 10 kHz liegen soll, um zu vermeiden, dass die absorbierenden Widerstände 20 und 21 mit dem niederfrequenten Nutzstrom von 50 Hz oder 60 Hz beaufschlagt werden. Entsprechende vorteilhafte Induktivitäts- und Kapazitätswerte liegen etwa bei 5 Millihenry bzw. 0,05 Mikrofarad.

Für den das angeschlossene Gerät speisenden Netzstrom mit der Frequenz von 50 Hz oder 60 Hz stellen die Spulen 22 und 23 praktisch einen verlustfreien Kurzschluss der parallelgeschalteten Widerstände 20 bzw. 21 dar, während der Parallelkondensator 24 in diesem Frequenzbereich eine praktisch unendlich grosse Impedanz hat.

Zur Unterdrückung asymmetrischer Störsignale können der Phasenleiter L und der Nulleiter N auf der Ausgangsseite des Störschutzfilters 19 zudem zusätzlich über je einen Kondensator 25 bzw. 26 mit dem Erdleiter E verbunden werden. Aus Sicherheitsgründen (Vermeidung unzulässig hoher Ableitströme zur Erde) müssen diese Kondensatoren in bekannter Weise kleinere Kapazitätswerte als der Parallelkondensator aufweisen, beispielsweise höchstens je 5 Nanofarad.

In Fig. 3 ist des weitern dargestellt, dass an das Störschutzfilter 19 das bereits anhand der Fig. 2 beschriebene Tiefpassfilter 11 angeschlossen ist, und zwar zufolge des dualen Charakters des Störschutzfilters 19 in Reihe zu diesem. In diesem Fall ist die Länge A des dazwischen liegenden Netzleitungsabschnitts, das heisst die Eingangsimpedanz des Tiefpassfilters 11, ohne Einfluss auf die Wirkung des Störschutzfilters 19. Einzig dann, wenn der Netzleitungsabschnitt eine sehr geringe Länge A aufweist, und am Eingang des Tiefpassfilters 11 tatsächlich der Parallelkondensator 12 angeordnet ist, kann der Parallelkondensator 24 des Störschutzfilters 19 entfallen.

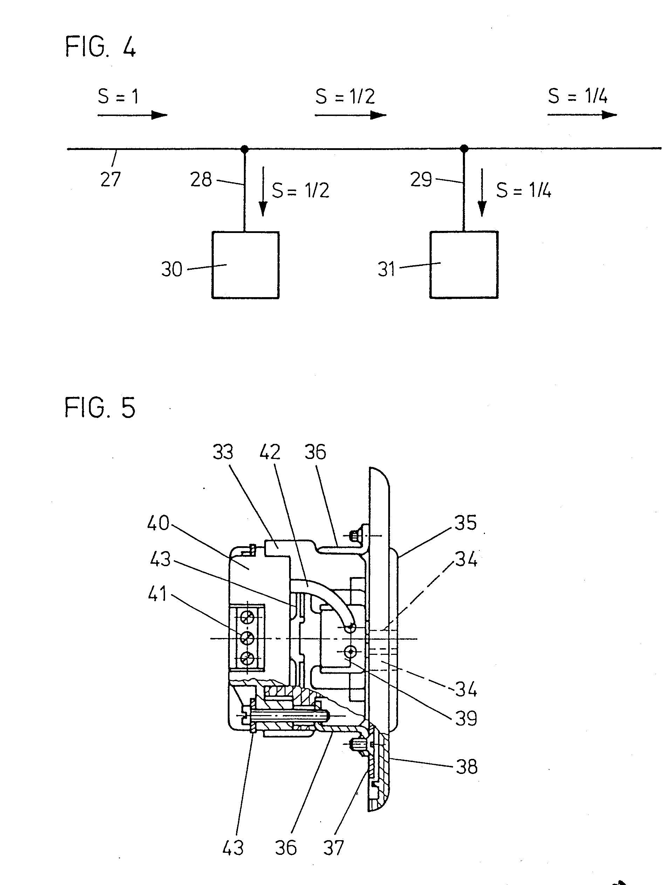

Das erfindungsgemässe Störschutzfilter kann in einem Netzleitungssystem, das heisst in einer Anordnung einer Wechselstrom-Netzleitung, an welche über jeweilige Stichleitungen mehrere Verbraucher angeschlossen sind, Störsignale wirkungsvoll und progressiv vermindern. Dies wird anhand der Fig. 4 schematisch kurz erläutert.

Eine Wechselstrom-Netzleitung 27 speist über mehrere Stichleitungen 28, 29 je einen Verbraucher 30 bzw. 31. Am Eingang jedes Verbrauchers 30, 31 oder im Abzweigpunkt jeder Stichleitung 28, 29 ist ein erfindungsgemässes Störschutzfilter (nicht dargestellt) angeordnet, beispielsweise in einer der Ausführungsformen der Fig. 1 bis 3. Zudem ist jedes Störschutzfilter an die Wellenimpedanz der Netzleitung 27 angepasst, wie dies vorgängig beschrieben worden ist.

Es wird angenommen, dass auf der Netzleitung 27 eine Störenergie S einfällt, die den normierten Wert (Spannung, Strom, Energieinhalt) eins hat. Am Orte der ersten Stichleitung 28 halbiert sich wegen der genannten Anpassung diese Störenergie, indem die eine Hälfte $S = 1/2$ der Störenergie auf der Netzleitung 27 weiterläuft und die andere Hälfte $S = 1/2$ über die Stichleitung 28 zum Verbraucher 30 läuft. In dem am Anfang oder am Ende der Stichleitung 28 angeordneten, erfindungsgemässen Störschutzfilter wird diese Störenergie absorbiert und in Wärme umgewandelt, so dass sie nicht zurück in die Netzleitung 27 gelangen kann. Dasselbe wiederholt sich am Orte der nächsten Stichleitung 29, so dass dann nur noch eine Störenergie $S = 1/4$ auf der Netzleitung 27 weiterläuft. Demnach verhindert das vorliegende Störschutzfilter in einem Netzleitungssystem mit Stichleitungen nicht nur das Eindringen von Störsignalen in die an die Stichleitungen angeschlossenen Verbraucher, sondern vermindert auch fortschreitend den Störenergiepegel auf der die Stichleitungen speisenden Netzleitung.

Das erfindungsgemässe Störschutzfilter kann in einer Vielzahl von Bauformen einschliesslich Gehäuse und Anschlusselemente für die einzelnen Leiter der Wechselstrom-Netzleitung und für den an die Netzleitung über das Störschutzfilter anzuschliessenden Verbraucher ausgeführt werden. Anhand der Fig. 5 wird nachstehend eine als Einbau-Wandsteckdose ausgebildete Bauform beschrieben, welche ein erfindungsgemässes Störschutzfilter enthält.

Diese Steckdose enthält in an sich bekannter Weise einen aus einem Isoliermaterial bestehenden Sockel 33, in welchen nur angedeutete Steckerbuchsen 34 eingelassen sind. Die Steckerbuchsen 34 sind auf der Vorderseite der Wandsteckdose bis auf entsprechende Löcher durch eine runde Platte 35 abgedeckt. Ueber Winkelelemente 36 ist der Sockel 33 an einer metallischen Montageplatte 37 befestigt, welche auf die Wand anschraubbar ist und durch eine isolierende Deckplatte 38 abgedeckt wird. Der Sockel 33 ist zudem mit Anschlussklemmen 39 versehen, welche mit den angedeuteten Steckerbuchsen 34 elektrisch verbunden sind.

Unterhalb des Sockels 33 ist ein Gehäuse 40 am Sockel 33 festgeklemmt, das ein vorliegendes Störschutzfilter, beispielsweise gemäss Figur 1, enthält. Das Gehäuse 40 ist mit weiteren Anschlussklemmen 41 versehen, in welche die Leiterdrähte der in der Wand befindlichen Netzleitung anschraubbar oder einklemmbar sind, also ein Phasenleiter, ein Nulleiter und ein Erdleiter, und welche den Klemmen L, N und E der Fig. 1 entsprechen. Ausgangsseitig ist das im Gehäuse befindliche Störschutzfilter über drei Leiter 42 mit den Anschlussklemmen 39 für die Steckerbuchsen 34 verbunden, wobei in Fig. 5 nur ein Leiter 42 sichtbar ist, während sich die anderen beiden Leiter 42 auf der Gegenseite befinden. Zwei Erdbänder 43 verbinden die metallischen Teile der Sockelbefestigung einschliesslich der Deckplatte 38 mit dem Erdanschluss des Störschutzfilters. In dieser Bauform kann eine übliche Wandsteckdose ein erfindungsgemässes Störschutzfilter ohne Vergrösserung der Steckdosenabmessungen und ohne zusätzliche Anschlussmassnahmen bei der Montage der Wandsteckdose aufnehmen.

Die anhand der Fig. 1 bis 3 beschriebenen Störschutzfilter können auch zur Absorption von Störenergie von der Geräteseite her verwendet und angeordnet werden. Das in Fig. 1 dargestellte Störschutzfilter 1 kann hierbei in beiden Richtungen unverändert verwendet werden, während beim Störschutzfilter 19 der Fig. 3 die Kondensatoren 24, 25, 26 auf der anderen Seite der Widerstände 20, 21 und der Spulen 22, 23 angeordnet werden müssen. In beiden Fällen der Fig. 2 und 3 ist das Störschutzfilter 1 bzw. 19 an die Geräteklemmen L', N', E' anzuschliessen.

## Patentansprüche

1. Störschutzfilter für eine Wechselstrom-Netzleitung und für mit dieser verbundene Geräte zur Verringerung von hochfrequenten Störungen, mit an die Leiter der Netzleitung angeschlossenen reaktiven Schaltungselementen, dadurch gekennzeichnet, dass das Störschutzfilter mindestens ein resistives Schaltungselement aufweist, welches in Kombination mit einem reaktiven Hochpassfilter eine zur Netzleitung bzw. zu den Geräten parallele Schaltungsanordnung bildet.

2. Störschutzfilter nach Anspruch 1, dadurch gekennzeichnet, dass es mindestens eine zwischen einen Phasenleiter und einen Nulleiter der Netzleitung geschaltete Reihenschaltung eines Widerstands und eines Kondensators enthält.

3. Störschutzfilter nach Anspruch 1 oder 2, dadurch gekennzeichnet, dass es je eine zwischen einen Phasenleiter und einen Erdleiter der Netzleitung sowie zwischen einen Nulleiter und den Erdleiter der Netzleitung geschaltete Reihenschaltung eines Widerstands und eines Kondensators enthält.

4. Störschutzfilter nach Anspruch 1, dadurch gekennzeichnet, dass es in einem Phasenleiter und in einem Nulleiter der Netzleitung je eine Parallelschaltung eines Widerstands und einer Induktivität enthält, und dass die beiden Parallelschaltungen ausgangsseitig durch einen Kondensator verbunden sind.

5. Störschutzfilter nach Anspruch 1, dadurch gekennzeichnet, dass es in einem Phasenleiter und in einem Nulleiter der Netzleitung je eine Parallelschaltung eines Widerstands und einer Induktivität enthält, und dass jede der Parallelschaltungen ausgangsseitig durch einen Kondensator mit einem Erdleiter der Netzleitung verbunden ist.

6. Störschutzfilter nach den Ansprüchen 4 und 5.

7. Störschutzfilter nach einem der Ansprüche 1 bis 6, dadurch gekennzeichnet, dass jedes resistive Schaltungselement einen solchen Widerstandswert hat, dass der ohmsche Anteil der Impedanz der durch das resistive Schaltungselement und das zugeordnete reaktive Hochpassfilter gebildeten Schaltungsanordnung angenähert gleich der Wellenimpedanz der Netzleitung ist.

8. Störschutzfilter nach einem der Ansprüche 1 bis 7, dadurch gekennzeichnet, dass die Grenzfrequenz des reaktiven Hochpassfilters bei etwa 10 kHz liegt.

9. Störschutzfilter nach einem der Ansprüche 1 bis 8, dadurch gekennzeichnet, dass es einem reaktiven StörschutzTiefpassfilter für das Gerät vorgeschaltet ist.

10. Störschutzfilter nach einem der Ansprüche 1 bis 9, dadurch gekennzeichnet, dass es in einem metallischen, mit einem Erdleiter verbundenen Gehäuse enthalten ist, welches mit einer mehrpoligen Steckeinrichtung für ein Netzanschlusskabel eines Geräts versehen ist.

11. Wechselstrom-Netzleitung mit mehreren Stichleitungen, an welche je ein Gerät anschliessbar ist, dadurch gekennzeichnet, dass in jede Stichleitung ein Störschutzfilter nach einem der Ansprüche 1 bis 10 geschaltet ist.

12. Netzsteckdose mit Steckeinrichtungen für ein Netzanschlusskabel eines Geräts, dadurch gekennzeichnet, dass sie ein Störschutzfilter nach einem der Ansprüche 1 bis 10 enthält, welches zwischen zur Netzsteckdose geführten Netzleitern und den Steckeinrichtungen der Netzsteckdose geschaltet ist.

0274347

FIG. 1

FIG. 2

FIG. 3

0274347

## FIG. 4

S = 1 →    S = 1/2 →    S = 1/4 →

27    28    ↓ S = 1/2    29    ↓ S = 1/4

30    31

## FIG. 5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | SIEMENS-BAUTEILE-INFORMATIONEN, Band 11, Nr. 2, Juni 1973, Seiten 24-27, München, DE; H. Wagner: "Neue Funk-Entstörungsgerätereihe für elektronische Anlagen" * Insgesamt * | 1,2,9-11 | H 03 H 1/00 |
| Y | Idem | 3-5,7, 12 | |
| A | Idem --- | 8 | |
| Y | DE-A-3 400 899 (FELLER AG) * Insgesamt * | 3,5,12 | |
| A | --- | 9,11 | |
| Y | FR-A-1 530 014 (NATIONAL RESEARCH DEVELOPMENT CORP.) * Insgesamt * --- | 4,5,7 | |
| X | DE-A-3 334 817 (SIEMENS AG) * Insgesamt * | 1,9 | RECHERCHIERTE SACHGEBIETE (Int. Cl.4) |
| A | --- | 2,3 | H 03 H |
| X | US-A-3 568 109 (R. NEUENS) * Figuren 5,8,9; Spalte 1, Zeile 6 - Spalte 2, Zeile 48; Spalte 4, Zeile 60 - Spalte 5, Zeile 73 * | 1,7 | |
| A | --- | 2,3,8 | |
| A | GB-A-1 078 280 (DUNILIER CONDENSER CO.) --- | | |
| A | FR-A-1 490 488 (F. MAYER) --- -/- | | |

Der vorliegende Recherchenbericht wurde für alle Patentansprüche erstellt

| Recherchenort | Abschlußdatum der Recherche | Prüfer |
|---|---|---|
| DEN HAAG | 02-03-1988 | DECONINCK E.F.V. |

Europäisches
Patentamt

**EUROPÄISCHER RECHERCHENBERICHT**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | US-A-2 939 095 (S. CHERTOK) ----- | | |
| | | | **RECHERCHIERTE SACHGEBIETE (Int. Cl.4)** |

Der vorliegende Recherchenbericht wurde für alle Patentansprüche erstellt

| Recherchenort | Abschlußdatum der Recherche | Prüfer |
|---|---|---|
| DEN HAAG | 02-03-1988 | DECONINCK E.F.V. |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
    ............................................................
& : Mitglied der gleichen Patentfamilie, übereinstimmendes
    Dokument

EPO FORM 1503 03.82 (P0403)